# EUROPEAN PATENT APPLICATION

(11) **EP 4 435 854 A1**
(43) Date of publication of application: **25.09.2024**
(21) Application number: 22896015.9
(22) Date of filing: 15.11.2022
(51) Int. Cl.: H01L 23/538, H01L 23/31, H01L 23/498, H01L 23/66, H01L 23/00, H01L 25/16, H01L 23/64

(54) **SIP MODULE**

(30) Priority: 18.11.2021 KR 20210159856; 26.01.2022 KR 20220011859
(71) Applicant: LG INNOTEK CO., LTD., Seoul 07796 (KR)
(72) Inventor: CHOI, Byung Hyun, Seoul 07796 (KR)
(74) Representative: Plasseraud IP
(86) International application number: PCT/KR2022/017970
(87) International publication number: WO 2023/090809

(57) **Abstract**

An SiP module according to an embodiment of the present invention comprises: a substrate; a first integrated chip (IC) embedded in the substrate; and a second IC disposed on one surface of the substrate, wherein the first IC and the second IC are disposed such that at least portions thereof overlap with respect to a first direction extending through the one surface of the substrate and the other surface thereof.

## Description

### [Technical Field]

The teachings in accordance with exemplary and non-limiting embodiments of the present invention relates to a SiP module, and more particularly to a miniaturized SiP module implementing dual baseband.

### [Background Arts]

While Bluetooth, cordless phones, and many other wireless devices use the noisy 2.4 GHz band that is present in most car hotspots, Wi-Fi 802.11ac (WiFi5) and later standards have the ability to operate in the less congested 5 GHz band.

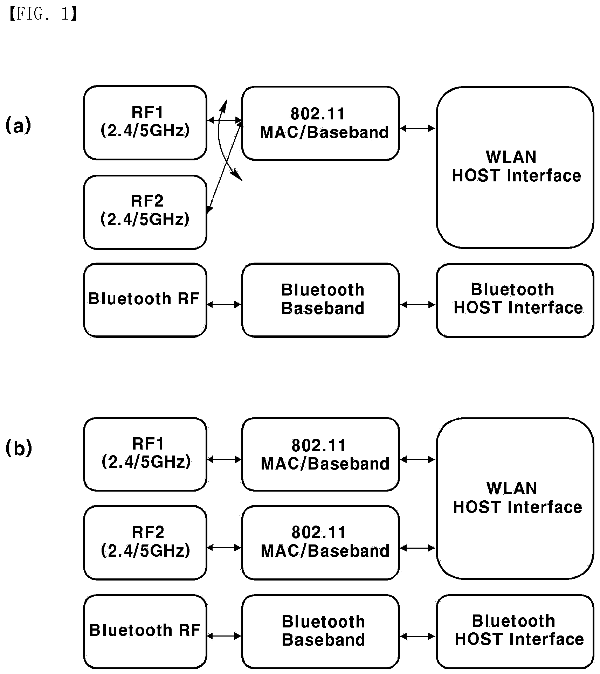

Referring to FIG. 1(a), most of today's automotive-grade Wi-Fi chipsets use a technique called "time-division multiplexing" to achieve simultaneous operation in the 2.4 GHz and 5 GHz bands, resulting in lower data rates per band. Many older Wi-Fi devices only operate in the 2.4 GHz band, so car hotspots should stick to the 2.4 GHz band for compatibility.

The 2.4 GHz band is also used by Bluetooth and other Wi-Fi devices, causing congestion, so transmission speeds may not be ideal. Next-generation applications will rely on the 5 GHz band to avoid congestion and mediocre quality of service, creating a dual-band requirement.

Referring to FIG. 1(b), real simultaneous dual band (RSDB) is a new type of Wi-Fi module that can transmit simultaneously in both the 2.4 GHz and 5 GHz bands. The real simultaneous dual-band (RSDB) Wi-Fi module can support two separate Wi-Fi networks. One is in the 2.4 GHz band and the other is in the 5 GHz band.

For in-vehicle environments, the 5GHz band allows for higher data rates and stronger Wi-Fi signals, while continuing to support legacy devices on 2.4GHz at optimal speeds. Because 5GHz Wi-Fi is faster and more reliable, high-priority Wi-Fi traffic can use this band, while the 2.4GHz band can be used for normal Wi-Fi traffic.

This means that real simultaneous dual band (RSDB) allows both 2.4 GHz and 5 GHz Wi-Fi networks to operate simultaneously and completely independent of each other to optimize the performance of each network, supporting legacy Wi-Fi devices that can connect to the internet in the vehicle while providing fast, clean and reliable 5 GHz Wi-Fi connectivity to the in-vehicle systems that need it most.

### [Disclosure]

### [Technical Field]

The technical challenge that the present invention addresses is to provide a miniaturized SiP module that implements dual baseband.

### [Technical Solution]

In order to solve the technical subject according to an exemplary embodiment of the present invention, an SiP module may comprise:
a substrate;
a first integrated chip (IC) embedded in the substrate; and
a second IC disposed on one surface of the substrate, wherein
the first IC and the second IC are disposed such that at least portions thereof overlap with respect to a first direction extending through the one surface of the substrate and the other surface thereof.

Preferably, but not necessarily, the first IC and the second IC may be of the same type and the same size, and the first IC and the second IC may be disposed in the same direction with respect to a second direction perpendicular to the first direction.

Preferably, but not necessarily, the first IC and the second IC may be connected with a single power capacitor.

Preferably, but not necessarily, one surface of the substrate may include a first component connected to the first IC, a second component connected to the second IC, and a third component connected to the first IC and the second IC.

Preferably, but not necessarily, the other surface of the substrate may include a heat dissipation pad, wherein the heat dissipation pad may include a first heat dissipation pad connected with the first IC and a second heat dissipation pad connected with the second IC.

Preferably, but not necessarily, the substrate may include a first heat pipe connecting the first IC and the first heat pad, and a second heat pipe connecting the second IC and the second heat pad, wherein the second heat pipe may be spaced apart from the first IC in a region where the first IC and the second IC overlap.

In order to solve the technical subject according to another exemplary embodiment of the present invention, an SiP module may comprise:
a substrate;
a first IC embedded in the interior of the substrate; and
a connecting terminal including a single pinmap on one surface of the substrate, wherein the connecting terminal and the first IC are disposed at least partially overlapping with respect to a first direction through the one surface and the other surface of the substrate.

Preferably, but not necessarily, the substrate may include a second IC disposed on the one surface of the substrate, wherein the second IC may be formed with a pin at a position corresponding to the connecting terminal.

Preferably, but not necessarily, the first IC and the second IC may be of the same type and the same size, and the first IC and the second IC may be disposed in the same direction with respect to a second direction perpendicular to the first direction.

Preferably, but not necessarily, the one surface of the substrate may include a first component in connection with the first IC, a second component in connection with the second IC, and a third component in connection with the first IC and the second IC.

### [Advantageous Effects of the Invention]

According to embodiments of the present invention, the overall size of the SiP module can be miniaturized by overlapping two single baseband chips on a single substrate.

Furthermore, by placing each single baseband chip in the same orientation, the components placed on the substrate can be arranged more efficiently, allowing for commonization of components and power structures and optimization of the RF port arrangement design.

Platformization of SiP modules also enables the freedom to implement modules containing only single baseband chips or modules implemented with dual baseband chips on a single board.

In addition, by placing separate heat sinks for each chipset, thermal interference between chipsets can be minimized, and performance degradation due to heat generation can be minimized.

### [Brief Description of Drawings]

FIG. 1(a) is a drawing to illustrate the operation of a single baseband chipset, and FIG. 1(b) is a drawing to illustrate the operation of a dual baseband chipset.
FIGS. 2 to 5 are drawings for illustrating an SiP module according to an exemplary embodiment of the present invention.

### [Best Mode]

Hereinafter, exemplary embodiments of the present invention will be described in detail with reference to the accompanying drawings.

However, it should be noted that the technical ideas of the present invention should not be construed as limited to some of the explained exemplary embodiments but may be embodied in mutually different various shapes, and one or more elements may be selectively coupled or substituted among exemplary embodiments as long as within the scope of technical concept of the present invention.

Furthermore, terms (including technical and scientific terms) used in the embodiments of the present invention, unless expressly specifically defined and described, are to be interpreted in the sense in which they would be understood by a person of ordinary skill in the art to which the present invention belongs, and commonly used terms, such as dictionary-defined terms, are to be interpreted in light of their contextual meaning in the relevant art.

Furthermore, the terms used in the embodiments of the invention are intended to describe the embodiments and are not intended to limit the invention.

In this specification, the singular may include the plural unless the context otherwise requires, and references to "at least one (or more) of A and (or) B and C" may include one or more of any combination of A, B, and C that may be assembled.

In addition, the terms first, second, A, B, (a), (b), and the like may be used to describe components of embodiments of the invention. Such terms are intended only to distinguish one component from another, and are not intended to limit the nature or sequence or order of such components by such terms.

Furthermore, when a component is described as "connected," "coupled," or "attached" to another component, it can include cases where the component is "connected," "coupled," or "attached" to the other component directly, as well as cases where the component is "connected," "coupled," or "attached" to another component that is between the component and the other component.

Furthermore, when described as being formed or disposed "above" or "below" each component, "above" or "below" includes not only when two components are in direct contact with each other, but also when one or more other components are formed or disposed between the two components. Furthermore, when expressed as "above" or "below", it may include the meaning of upward as well as downward with respect to a single component.

FIG. 1(a) is a drawing to illustrate the operation of a single baseband chipset, and FIG. 1(b) is a drawing to illustrate the operation of a dual baseband chipset.

FIG. 1(a) is a block diagram of a communication module including a single baseband chipset, which can operate simultaneously in the 2.4 GHz and 5 GHz bands via time divide operation, but at the cost of reduced communication performance, such as lower data rates per band.

FIG. 1(b) shows a block diagram of a communication module including a dual baseband chipset, which can transmit simultaneously in both 2.4 GHz and 5 GHz bands via real simultaneous dual band (RSDB).

Typically, a dual baseband chipset is constructed by placing two single baseband chipsets side by side, which increases the size of the chipset in the communication module. To solve this problem, the SiP module according to one embodiment of the present invention can minimize the overall size by embedding one single baseband chipset inside the substrate and arranging the other single baseband chipset on the substrate but overlapping with the embedded single baseband chipset, and by arranging each single baseband chipset in the same orientation, the commonization of components and optimal arrangement of RF ports can be achieved.

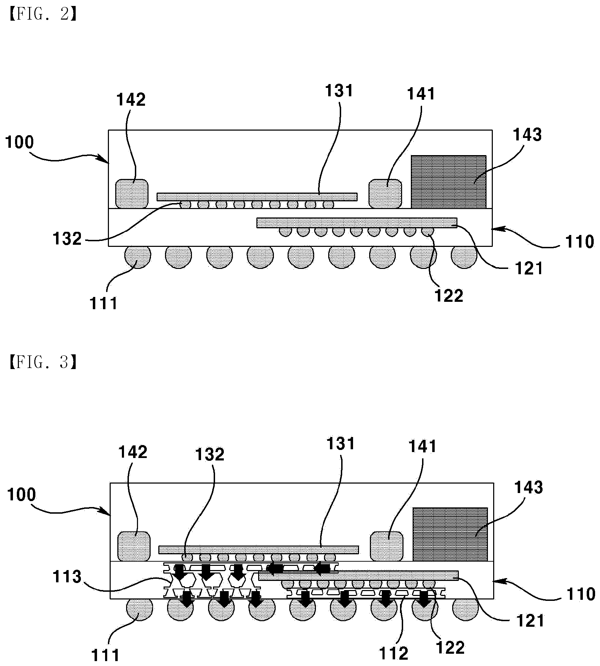

FIGS. 2 to 5 are drawings for illustrating an SiP module according to an exemplary embodiment of the present invention.

An SiP module (100) according to one exemplary embodiment of the present invention may include a substrate (110), a first IC (121), and a second IC (131).

The substrate (110) may be a printed circuit board (PCB). The substrate (110) may be formed in a single layer. The substrate (110) may be formed in a plurality of layers. Components may be disposed on one surface of the substrate (110), and a substrate bump (111) may be disposed on the other surface of the substrate (110).

The interior of the substrate (110) may include a first IC (121) that is embedded. As used in the present invention, "embedded technology" refers to the technology of embedding an electronic component inside a substrate, as opposed to conventionally bonding an electronic component on a substrate surface via surface mount technology (SMT). The first IC (121) may include a first bump (122) on the other surface of the first IC (121).

The second IC (131) may be disposed on one surface of the substrate (110). The second IC (131) and the first IC (121) may be disposed to at least partially overlap. The second IC (131) may be disposed to overlap the first IC (121) with respect to a first direction through the one surface and the other surface of the substrate (110). This may enable implementation of dual baseband operation in a single SiP module.

The second IC (131) may be bonded to the substrate (110) by flip chip technology. The second IC (131) may include a second bump (132) on the other surface of the second IC (131).

The flip-chip technology is a form of wireless bonding, a type of device mounting technology, in which a chip is attached to a substrate without the use of additional connection structures such as metal leads (wires) or intermediate media such as a ball grid array (BGA), but instead is directly fused using lead bumps that become electrodes on the underside of the chip. This technology enables the package to be the same size as the chip, which is advantageous for small size and light weight, excellent thermal stability, high current application rate and reaction speed, and a much smaller distance between the electrodes.

The first IC (121) and the second IC (131) may be the same type of chip. The first IC (121) and the second IC (131) may be the same type of single baseband chip. The first IC (121) and the second IC (131) may be the same type of Wi-Fi chipset. The first IC (121) and the second IC (131) may be different types of single baseband chips. The first IC (121) and the second IC (131) may have the same size. The first IC (121) and the second IC (131) may have different sizes. The first IC (121) and the second IC (131) may be disposed in the same direction relative to a first direction perpendicular to a first direction through the one surface and the other surface of the substrate (110).

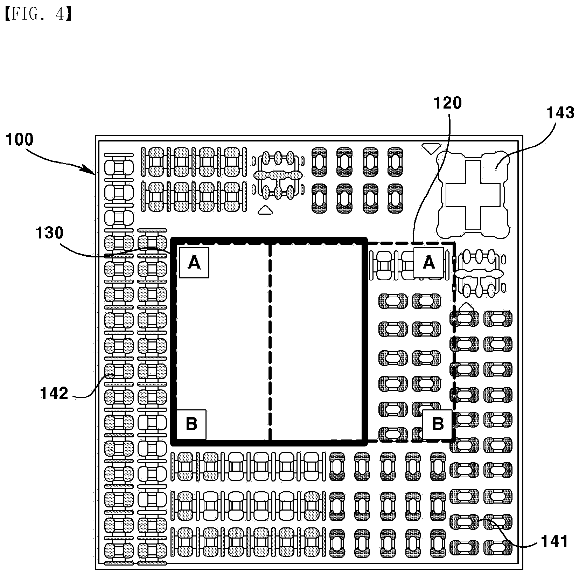

Referring to FIG. 4, if the first IC (121) and the second IC (131) are the same type of chip, the same components on each chip may be disposed facing the same direction of the substrate (110).

For example, the substrate (110) may include a first side and a third side disposed opposite each other, and a second side and a fourth side disposed opposite each other, wherein the first side is connected to the second side and the fourth side, and the third side is connected to the second side and the fourth side.

If the A component of the first IC (121) is disposed facing the first side of the substrate (110) and the B component is disposed facing the third side of the substrate (110), the A component of the second IC (131) may be disposed facing the first side of the substrate (110) and the B component may be disposed facing the third side of the substrate (110).

Since the first IC (121) and the second IC (131) are disposed on the substrate (110) in the same direction as each other, the components disposed on the substrate (110) can be positioned more efficiently. Components disposed on the substrate (110) may include a temperature compensated crystal oscillator (TCXO), a clock buffer, an RF switch, and various passive elements.

The first IC (121) and the second IC (131) may share components disposed on the substrate (110), and may optimize the arrangement of the RF ports. In addition, the interfaces disposed on the substrate (110) may be arranged to avoid overlapping or bunching, which may be advantageous for shielding and heat dissipation designs.

The first IC (121) and the second IC (131) may be connected with a single power capacitor. The first IC (121) and the second IC (131) may share a capacitor from the same power source, which may simplify the circuitry.

One surface of the substrate (110) may include a first component (141) in connection with the first IC (121), a second component (142) in connection with the second IC (131), and a third component (143) in connection with the first IC (121) and the second IC (131). On one surface of the substrate (110), the first component (141) may be disposed in a position adjacent to the first IC (121), the second component (142) may be disposed in a position adjacent to the second IC (131), and the third component (143) may be disposed in a region adjacent to the first IC (121) and the second IC (131) in common.

FIG. 4 illustrates an exemplary arrangement of the first to third parts (141, 142, 143) disposed on the substrate (110), wherein, referring to FIG. 4, the first component (141) may be disposed predominantly on the right side of the substrate (110) adjacent to the first IC (121), a second component (142) may be disposed predominantly in a left-hand direction of the substrate (110) adjacent to the second IC (131), and a third component (143) may be disposed in a lower left and upper right-hand direction of the substrate (110) in areas that are in common proximity to the first IC (121) and the second IC (131). This is exemplary only and it is appreciated that various arrangements are possible.

One surface of the substrate (120) may include connecting terminal comprising a single pinmap. The second IC (131) disposed on the one surface of the substrate (110) may have pins formed at locations corresponding to the connecting terminal on the substrate (110). The SiP module (100) may have a structure in which a single baseband chip is embedded. The SiP module (100) may have a structure in which one single baseband chip is embedded and another single baseband chip is arranged to at least partially overlap the embedded single baseband chip.

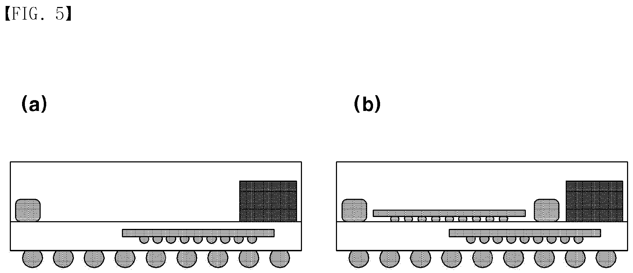

FIG. 5(a) is an SiP module including a single baseband chip, and FIG. 5(b) is an SiP module implemented as a dual baseband including two single baseband chips. In other words, by including a connecting terminal including a single pinmap on one surface of the substrate (110), it is possible to attach and detach the second IC (131) to the substrate (110), so that an SiP module including a single baseband chip or an SiP module including a dual baseband chip can be optionally fabricated when fabricating the SiP module.

Therefore, it is not necessary to manufacture a separate substrate for each SiP module with a single baseband chip or an SiP module with a dual baseband chip. The substrates of the SiP modules according to the communication method can be platformed, and one substrate can be utilized as a motherboard.

A heat dissipation pad may be disposed on the other surface of the substrate (110).

Specifically, the heat dissipation pad may be a thermal (conductive) tape. The heat dissipation pad may have high thermal conductivity to reduce heat generated inside the SiP module. The heat dissipation pad may be in the form of a tape. The heat dissipation pad may be in the form of a double-sided tape. The heat dissipation pad may include a first heat dissipation pad in connection with the first IC (121) and a second heat dissipation pad in connection with the second IC (131). With respect to a first direction through one surface of the substrate (110), the first heat dissipation pad may be disposed to overlap with the first IC (121) and the second heat dissipation pad may be disposed to overlap with the second IC (131).

The heat dissipation pad may include a first heat pipe (112) connecting the first IC (121) and the first heat dissipation pad, and a second heat pipe (113) connecting the second IC (131) and the second heat dissipation pad. The first heat pipe (112) and the second heat pipe (113) may be embedded within the substrate (110).

Referring to FIG. 3, the first heat pipe (112) may be directly connected to the first IC (121) and may dissipate heat generated by the first IC (121) to the first heat dissipation pad. The second heat pipe (113) may be in direct connection with the second IC (131) and can dissipate heat generated by the second IC (131) to the first heat dissipation pad.

In an area where the first IC (121) and the second IC (131) overlap, the second heat pipe (113) may be spaced apart from the first IC (121). Heat generated by the second IC (131) may be dissipated to the second heat dissipation pad with minimal impact on the first IC (121). In this way, the first IC (121) and the second IC (131) may have different thermal flows, thereby reducing the interference of heat between the first IC (121) and the second IC (131).

Furthermore, since the first IC (121) and the second IC (131) are each connected to a separate heat dissipation pad, thermal interference can be prevented from occurring on the bottom surface of the substrate (110), and performance degradation can be prevented from occurring due to heat generation of each chipset.

According to exemplary embodiments of the present invention, the overall size of the SiP module can be miniaturized by overlapping two single baseband chips on a single substrate. Furthermore, by placing each single baseband chip in the same orientation, the components placed on the substrate can be arranged more efficiently, allowing for commonization of components and power structures and optimization of the RF port arrangement design. Platformization of SiP modules also enables the freedom to implement modules containing only single baseband chips or modules implemented with dual baseband chips on a single board. In addition, by placing separate heat dissipation pad for each chipset, thermal interference between chipsets can be minimized, and performance degradation due to heat generation can be minimized.

One having ordinary knowledge in the technical field to which the present embodiments relate will understand that variations may be implemented without departing from the essential characteristics of the materials described above. The disclosed methods are therefore to be considered from an illustrative and not a limiting point of view. The scope of the invention is shown in the claims of the patent and not in the foregoing description, and all differences within the scope of the claims are to be construed as being included in the invention.

## Claims

1. An SiP module comprising:
a substrate;
a first integrated chip (IC) embedded in the substrate; and
a second IC disposed on one surface of the substrate,
wherein the first IC and the second IC are disposed such that at least portions thereof overlap with respect to a first direction extending through the one surface of the substrate and the other surface thereof.

2. The SiP module of claim 1, wherein the first IC and the second IC are of the same type and the same size, and the first IC and the second IC are disposed in the same direction with respect to a second direction perpendicular to the first direction.

3. The SiP module of claim 1, wherein the first IC and the second IC are connected with a single power capacitor.

4. The SiP module of claim 1, wherein one surface of the substrate comprises a first component connected to the first IC, a second component connected to the second IC, and a third component connected to the first IC and the second IC.

5. The SiP module of claim 1, wherein the other surface of the substratecomprises a heat dissipation pad, and
wherein the heat dissipation pad comprises a first heat dissipation pad connected with the first IC and a second heat dissipation pad connected with the second IC.

6. The SiP module of claim 5, wherein the substrate comprisesa first heat pipe connecting the first IC and the first heat pad, and a second heat pipe connecting the second IC and the second heat pad, and
wherein the second heat pipe is spaced apart from the first IC in a region where the first IC and the second IC overlap.

7. An SiP module comprising:
a substrate;
a first IC embedded in the interior of the substrate; and
a connecting terminal comprising a single pinmap on one surface of the substrate,
wherein the connecting terminal and the first IC are disposed at least partially overlapping with respect to a first direction through the one surface and the other surface of the substrate.

8. The SiP module of claim 7, wherein the substrate comprises a second IC disposed on the one surface of the substrate, and
wherein the second IC is formed with a pin at a position corresponding to the connecting terminal.

9. The SiP module of claim 8, wherein the first IC and the second IC are of the same type and the same size, and the first IC and the second IC are disposed in the same direction with respect to a second direction perpendicular to the first direction.

10. The SiP module of claim 8, wherein the one surface of the substrate comprises a first component in connection with the first IC, a second component in connection with the second IC, and a third component in connection with the first IC and the second IC.
